# EUROPÄISCHE PATENTSCHRIFT

(11) **EP 2 095 420 B1**
(45) Veröffentlichungstag und Bekanntmachung des Hinweises auf die Patenterteilung: **02.10.2019**
(21) Anmeldenummer: 07846279.3
(22) Anmeldetag: 30.10.2007
(51) Int. Cl.: H01L 23/552, H05K 1/02

(54) **SCHALTUNGSANORDNUNG ZUR ENERGIEVERSORGUNG EINES INTEGRIERTEN SCHALTKREISES**
CIRCUIT ARRANGEMENT FOR SUPPLYING AN INTEGRATED CIRCUIT WITH ENERGY
CIRCUITERIE POUR L'ALIMENTATION EN ÉNERGIE D'UN CIRCUIT INTÉGRÉ

(30) Priorität: 27.11.2006 DE 102006056181; 09.07.2007 DE 102007032092
(43) Veröffentlichungstag der Anmeldung: 02.09.2009
(73) Patentinhaber: Conti Temic Microelectronic GmbH, 90411 Nürnberg (DE)
(72) Erfinder: SCHUBERT, Göran, 91126 Schwabach (DE)
(74) Vertreter: Bonn, Roman Klemens
(86) Internationale Anmeldenummer: PCT/DE2007/001944
(87) Internationale Veröffentlichungsnummer: WO 2008/064627

(56) Entgegenhaltungen:
- WO-A-2006/094469
- DE-A1- 10 039 392
- US-B1- 7 085 143

## Beschreibung

Die Erfindung betrifft eine Schaltungsanordnung zur Energieversorgung eines integrierten Schaltkreises.

In der Automobiltechnik finden zunehmend integrierte Schaltkreise, beispielsweise in Form von Mikroprozessoren oder Mikrocontrollern, Verwendung. Zu deren Energieversorgung ist üblicherweise ein parallel zwischen einem Versorgungseingang des integrierten Schaltkreises und einer Schaltungsträgermasse geschalteter externer Abblockkondensator sowie eine parallel dazu geschaltete Spannungsquelle vorgesehen. Sowohl der Abblockkondensator als auch die Spannungsquelle sind direkt mit der Schaltungsträgermasse verbunden. Die Spannungsquelle lädt den Abblocckondensator, wobei die dem integrierten Schaltkreis zugeführte Energie dem Abblockkondensator mittels eines Entladestroms entzogen wird. Dadurch soll eine möglichst realistische Nachbildung einer idealen Spannungsquelle erreicht werden. Der Abblockkondensator hat hierzu üblicherweise eine Abblockkapazität von etwa 100 nF. Die beschriebene Schaltungsanordnung ist detailliert in der WO 2006/094469 A1 diskutiert, auf die verwiesen wird. Nachteilig bei der beschriebenen Schaltungsanordnung ist, dass diese zu einer unerwünscht hohen Abstrahlung von elektromagnetischer Energie führt, insbesondere wenn eine Taktfrequenz des integrierten Schaltkreises größere Werte als 10 MHz annimmt. Die EMV-Anforderungen der Automobilbranche können dann nicht mehr erfüllt werden.

Aus der WO 2006/094469 A1 ist eine Schaltungsanordnung bekannt, mit deren Hilfe ein integrierter Schaltkreis auch bei einer hohen Taktfrequenz, insbesondere im MHz-Bereich, mit Energie versorgt werden kann, wobei gleichzeitig die Abstrahlung elektromagnetischer Energie im Vergleich zu der oben beschriebenen Schaltungsanordnung deutlich reduziert ist und die EMV-Anforderungen der Automobilbranche eingehalten werden können. Die reduzierte Abstrahlung wird dadurch erreicht, dass auf die externe Beschaltung mit dem Abblockkondensator verzichtet wird und stattdessen eine innerhalb des integrierten Schaltkreises ohnehin vorhandene interne Buskapazität genutzt wird. Weiterhin wird anstelle einer niederohmigen Spannungsquelle eine Versorgungseinheit mit einem möglichst hohen Innenwiderstand verwendet. Durch diese Maßnahmen wird eine Frequenzentkopplung der Auf- und der Entladung der internen Buskapazität erzielt. Während das Entladen der Buskapazität weiterhin mit der hohen Taktfrequenz stattfindet, erfolgt das Aufladen dagegen bei einer deutlich tieferen Frequenz. Dadurch, dass der hochfrequente Entladevorgang nur räumlich eng begrenzt innerhalb des integrierten Schaltkreises stattfindet und der Ladevorgang niederfrequent ist, bewirken sowohl der Lade- als auch der Entladevorgang keine relevante Abstrahlung von elektromagnetischer Energie. Nachteilig ist jedoch, dass die genutzte interne Buskapazität nur etwa 5 nF beträgt, so dass bei der Versorgung der Schaltkreislast Spannungsschwankungen auftreten, die durch softwarebedingte Lastschwankungen verursacht sind.

Eine weitere Schaltungsanordnung aus dem Stand der Technik ist aus der US 7,085,143 B1 bekannt.

Der Erfindung liegt daher die Aufgabe zugrunde, eine Schaltungsanordnung zur Energieversorgung eines integrierten Schaltkreises bereitzustellen, die eine zuverlässige und abstrahlungsarme Versorgung des integrierten Schaltkreises mit Energie gewährleistet.

Diese Aufgabe ist erfindungsgemäß gelöst durch eine Schaltungsanordnung mit den im Anspruch 1 angegebenen Merkmalen. Erfindungsgemäß ist zur Verminderung der lastbedingten Spannungsschwankungen ein externer Pufferkondensator vorgesehen, der parallel zu der Schaltkreislast geschaltet ist und an einen Versorgungsanschluss und einen Masseanschluss des integrierten Schaltkreises angeschlossen ist. Der Pufferkondensator ist somit extern nur mit der internen Schaltkreismasse des integrierten Schaltkreises verbunden. Der Pufferkondensator ist nicht direkt mit der Schaltungsträgermasse des Schaltungsträgers verbunden. Weiterhin ist eine Versorgungseinheit vorgesehen, die derart ausgebildet ist, dass diese zumindest bei der Taktfrequenz des integrierten Schaltkreises ein Stromquellenverhalten aufweist. Die Kombination einer derartigen Versorgungseinheit mit der Maßnahme, dass der Pufferkondensator nur mit der internen Schaltkreismasse und nicht mit der externen Schaltungsträgermasse direkt verbunden ist, bewirkt zum einen eine Frequenzentkopplung zwischen der Auf- und der Entladung des extern angeschlossenen Pufferkondensators sowie der internen Schaltkreiskapazität und zum anderen ein Begrenzen der hochfrequenten Entladeströme auf den Bereich des integrierten Schaltkreises und des Pufferkondensators. Während das Entladen des Pufferkondensators weiterhin mit der hohen Taktfrequenz des integrierten Schaltkreises stattfindet, erfolgt das externe Aufladen des Pufferkondensators über den Schaltungsträger mit einer deutlich niedrigeren Frequenz. Die niedrigere Frequenz ergibt sich aufgrund des Tiefpassverhaltens des Ladekreises. Der Pufferkondensator und die interne Schaltkreiskapazität bilden zusammen mit einem hochohmigen Innenwiderstand der Versorgungseinheit, der durch das Stromquellenverhalten bedingt ist, ein RC-Glied mit dem Tiefpassverhalten aus. Alternativ oder zusätzlich kann der Pufferkondensator und die interne Schaltkreiskapazität zusammen mit der Versorgungseinheit ein LC-, ein FerritbeadC-Glied oder eine Kombination der genannten Glieder ausbilden, so dass ein Tiefpassverhalten erzielt wird. Die im Zusammenhang mit der Aufladung des Pufferkondensators auftretenden Ladefrequenzen sind um mindestens eine Größenordnung kleiner als die im Zusammenhang mit der Entladung auftretenden Entladefrequenzen. Die hochfrequenten Entladeströme sind räumlich eng begrenzt und liegen im Wesentlichen nur innerhalb des integrierten Schaltkreises und des extern angeschlossenen Pufferkondensators vor. Die niederfrequenten Ladeströme durchlaufen zwar auch den Schaltungsträger, auf den der integrierte Schaltkreis montiert ist, jedoch erzeugen diese aufgrund der niedrigen Frequenz keine relevante Abstrahlung. Die Abstrahlung von elektromagnetischer Energie ist somit sehr gering. Die hochfrequenten Entladeströme erzeugen aufgrund der engen räumlichen Begrenzung innerhalb des integrierten Schaltkreises und des Pufferkondensators und die niederfrequenten Ladeströme aufgrund der niedrigen Frequenz keine relevante Abstrahlung. Durch den Pufferkondensator, der eine im Vergleich zu der internen Schaltkreiskapazität deutlich größere Pufferkapazität aufweist, ist eine zuverlässige und im Wesentlichen schwankungsfreie Spannungsversorgung der Schaltkreislast gewährleistet. Die erfindungsgemäße Schaltungsanordnung erlaubt die Verwendung von herkömmlichen integrierten Schaltkreisen, wie beispielsweise Mikrocontrollern, die mindestens über mehrere intern miteinander verbundene Masseanschlüsse und vorteilhafter Weise über mehrere intern miteinander verbundene Versorgungsanschlüsse verfügen.

Eine Ausbildung der Versorgungseinheit nach Anspruch 2 verhindert, dass die niederfrequenten Ladeströme von hochfrequenten Ladeströmen überlagert werden, die aufgrund von Oberwellen der Taktfrequenz entstehen.

Eine Schaltungsanordnung nach Anspruch 3 verhindert konstruktiv, dass sich ein im integrierten Schaltkreis generierter hochfrequenter Stromkreis über die Schaltungsträgermasse schließen kann.

Eine Ausbildung der Schaltungsanordnung nach Anspruch 4 erlaubt eine bessere thermische Anbindung des integrierten Schaltkreises an die Schaltungsträgermasse. Für nahe beieinanderliegende Masseanschlüsse gilt, dass aufgrund des geringen Abstandes die zwischen den Masseanschlüssen ausgebildete Induktivität und damit der Spannungsabfall, verursacht durch einen durch diese Induktivität fließenden Strom, gering ausfällt. Dies ermöglicht das Parallelschalten von direkt nebeneinander liegenden Masseanschlüssen der internen Schaltkreismasse zu der Schaltungsträgermasse mit einer nur geringen Verschlechterung des stromgetriebenen Common-Mode-Abstrahlverhaltens. Dies führt zu einer zuverlässigeren und besseren Wärmeableitung aus dem integrierten Schaltkreis.

Bei einer Überschreitung des zulässigen Abstrahlungsgrenzwertes durch die stromgetriebene Common-Mode-Abstrahlung kann die Anzahl der Schaltungsträgerverbindungen sukzessive verringert werden, bis ein akzeptables Abstrahlungsverhalten erreicht ist. Bei der Verringerung der Schaltungsträgerverbindungen sollten immer die am weitesten voneinander entfernten Schaltungsträgerverbindungen entfernt werden.

Eine besonders effiziente Wärmeableitung wird erzielt, wenn das sogenannte Die des integrierten Schaltkreises thermisch gut an die Masseanschlüsse angebunden ist, wie dies bei Ball-Grid-Arrays durch Einsetzen von sogenannten Thermo-Vias im Die-Träger erreichbar ist, die elektrisch mit den Masse-Balls verbunden sind und die Thermo-Vias für die Anbindung der Masse-Balls an die flächig ausgeführte Schaltungsträgermasse mittels Via in PAD-Technologie ausgebildet sind.

Eine Schaltungsanordnung nach Anspruch 5 ermöglicht das Anschließen eines weiteren schnell taktenden oder getakteten integrierten Schaltkreises ohne nennenswerte Verschlechterung der stromgetriebenen Common-Mode-Abstrahlung.

Eine Schaltungsanordnung nach den Ansprüchen 6 bis 8 stellen alternative Möglichkeiten dar, wie der weitere integrierte Schaltkreis einfach mit Energie versorgbar ist.

Ein Pufferkondensator nach Anspruch 7 führt zu einer Verminderung von Spannungsschwankungen bei der Versorgung der Schaltkreislast des weiteren integrierten Schaltkreises. Der Pufferkondensator ist in entsprechender Weise nur mit einem Versorgungsanschluss und einem Masseanschluss des weiteren integrierten Schaltkreises verbunden. Eine direkte Verbindung zu der Schaltungsträgermasse existiert nicht. Somit bewirkt der Pufferkondensator keine nennenswerte Verschlechterung der Common-Mode-Abstrahlung der Schaltungsanordnung.

Ein Kommunikationsstromkreis nach Anspruch 8 ermöglicht eine Kommunikation zwischen den integrierten Schaltkreisen, beispielsweise zwischen einem Mikroprozessor und einem externen Speicher, wobei der Kommunikationsstromkreis als Adress- und Datenbus ausgebildet sein kann. Dadurch, dass der Kommunikationsstromkreis keine eigene Verbindung zur Schaltungsträgermasse aufweist, verursacht der Kommunikationsstromkreis keine nennenswerte Erhöhung der stromgetriebenen Common-Mode-Abstrahlung.

Eine Ausbildung der Schaltungsanordnung nach Anspruch 9 ermöglicht eine einfache Realisierung des Kommunikationsstromkreises.

Weitere Merkmale, Vorteile und Einzelheiten der Erfindung ergeben sich aus der nachfolgenden Beschreibung von Ausführungsbeispielen anhand der Zeichnung. Es zeigen:
- Fig. 1: eine Prinzipdarstellung einer Schaltungsanordnung gemäß einem ersten Ausführungsbeispiel,
- Fig. 2: ein Ersatzschaltbild der Schaltungsanordnung gem. Fig. 1,
- Fig. 3: eine Prinzipdarstellung einer Schaltungsanordnung gemäß einem zweiten Ausführungsbeispiel,
- Fig. 4: eine Prinzipdarstellung einer Schaltungsanordnung gemäß einem dritten Ausführungsbeispiel,
- Fig. 5: ein Ersatzschaltbild der Schaltungsanordnung gemäß Fig. 4,
- Fig. 6: eine Prinzipdarstellung einer Schaltungsanordnung gemäß einem vierten Ausführungsbeispiel,
- Fig. 7: ein Ersatzschaltbild der Schaltungsanordnung gemäß Fig. 6,
- Fig. 8: eine Prinzipdarstellung einer Schaltungsanordnung gemäß einem fünften Ausführungsbeispiel, und
- Fig. 9: ein Ersatzschaltbild der Schaltungsanordnung gem. Fig. 8.

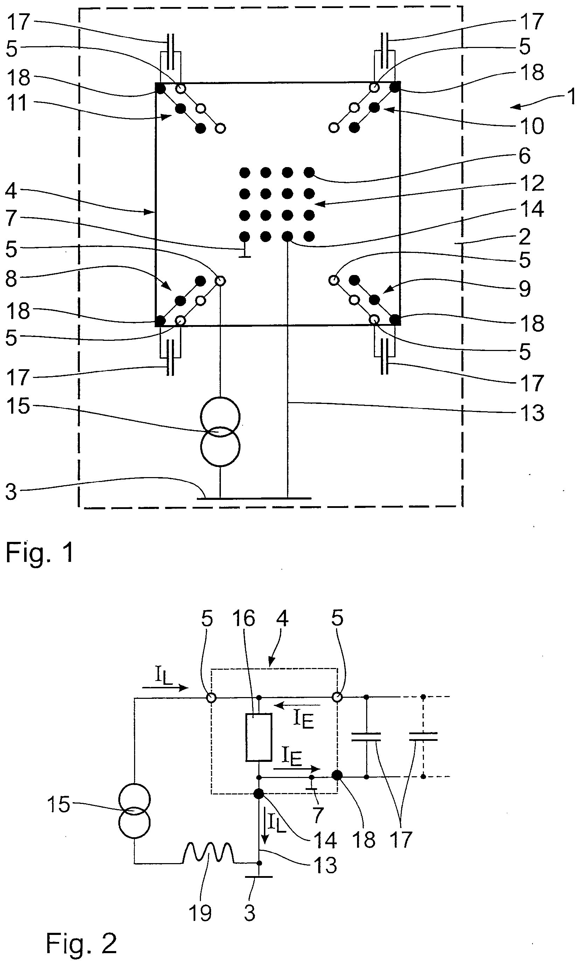

Nachfolgend wird anhand der Fig. 1 und 2 ein erstes Ausführungsbeispiel der Erfindung beschrieben. Eine Schaltungsanordnung 1 zur Energieversorgung eines integrierten Schaltkreises weist einen Schaltungsträger 2 mit einer elektrischen Schaltungsträgermasse 3 und einen integrierten Schaltkreis 4 auf. Der Schaltungsträger 2 ist beispielsweise als Leiterplatte ausgebildet. Der integrierte Schaltkreis 4 wird allgemein üblich auch als IC bezeichnet, wobei IC als Abkürzung für Integrated Circuit steht. Der integrierte Schaltkreis 4 weist im Betrieb eine Taktfrequenz f1 auf, wobei die Taktfrequenz 10 MHz oder größer ist. Der integrierte Schaltkreis 4 kann intern taktend oder extern getaktet ausgebildet sein. Der integrierte Schaltkreis 4 ist auf dem Schaltungsträger 2 angeordnet.

Der integrierte Schaltkreis 4 weist an einer dem Schaltungsträger 2 abgewandten Seite mehrere Versorgungsanschlüsse 5 und mehrere Masseanschlüsse 6 auf. Die Versorgungsanschlüsse 5 sind schaltkreisintern miteinander verbunden und in Fig. 1 als Kreise gekennzeichnet. Die Masseanschlüsse 6 sind entsprechend schaltkreisintern miteinander verbunden und mit einer Schaltkreismasse 7 verbunden. Die Masseanschlüsse 6 sind in Fig. 1 durch Punkte gekennzeichnet. Die Versorgungsanschlüsse 5 und die Masseanschlüsse 6 werden allgemein üblich als Pins bezeichnet.

Die Versorgungsanschlüsse 5 und die Masseanschlüsse 6 bilden insgesamt fünf Anschlussgruppen aus. Eine erste Anschlussgruppe 8 ist in einem Eckbereich des integrierten Schaltkreises 4 angeordnet und umfasst jeweils drei Versorgungsanschlüsse 5 und Masseanschlüsse 6, die paarweise zueinander angeordnet sind und jeweils ein Anschlusspaar bilden. Eine entsprechende zweite Anschlussgruppe 9, eine dritte Anschlussgruppe 10 und eine vierte Anschlussgruppe 11 sind in den weiteren Eckbereichen des integrierten Schaltkreises 4 angeordnet. Eine fünfte Anschlussgruppe 12 ist mittig an dem integrierten Schaltkreis 4 angeordnet und umfasst nur Masseanschlüsse 6, die paarweise gleichmäßig beabstandet in einem Quadrat angeordnet sind. Ein Masseanschluss 6 der fünften Anschlussgruppe ist über eine elektrisch leitende Masseverbindung 13 direkt mit der Schaltungsträgermasse 3 verbunden. Dieser Masseanschluss 6 wird explizit als erster Masseanschluss 14 bezeichnet.

Zur Energieversorgung des integrierten Schaltkreises 4 ist eine Versorgungseinheit 15 vorgesehen. Die Versorgungseinheit 15 ist mit einem Versorgungsanschluss 5 der ersten Anschlussgruppe 8 und der Schaltungsträgermasse 3 verbunden. Die Versorgungseinheit 15 dient zur Versorgung einer Schaltkreislast 16 mit elektrischer Energie. Die Schaltkreislast 16 ist in dem Ersatzschaltbild gemäß Fig. 2 durch eine Impedanz gekennzeichnet, die einen Impedanzwert Z aufweist. Die Versorgungseinheit 15 ist derart ausgebildet, dass diese zumindest bei der Taktfrequenz f1 und vorteilhafter Weise bei den ersten drei, insbesondere bei den ersten sieben, und insbesondere bei den ersten zehn Oberwellen der Taktfrequenz f1 ein Stromquellenverhalten aufweist. Stromquellenverhalten bedeutet, dass die Versorgungseinheit 15 einen hohen Innenwiderstand aufweist und einen von der Schaltkreislast 16 im Wesentlichen unabhängigen Versorgungsstrom liefert. Ein ideales Stromquellenverhalten ist in Realität nur näherungsweise erreichbar.

Zur Verminderung von lastbedingten Spannungsschwankungen sind Pufferkondensatoren 17 vorgesehen, die extern an den integrierten Schaltkreis 4 angeschlossen sind. Die Pufferkondensatoren 17 sind jeweils an einen Versorgungsanschluss 5 und einen Masseanschluss 6 der ersten bis vierten Anschlussgruppe 8, 9, 10, 11 angeschlossen. Der mit den Pufferkondensatoren 17 jeweils direkt verbundene Masseanschluss 6 wird explizit als zweiter Masseanschluss 18 bezeichnet. Die Pufferkondensatoren 17 sind parallel zu der Schaltkreislast 16 und einer internen Schaltkreiskapazität, die in den Fig. 1 und 2 nicht dargestellt ist, geschalten. Die Pufferkondensatoren 17 weisen jeweils eine Pufferkapazität C auf. Die Pufferkapazitäten C der Pufferkondensatoren 17 sind vorzugsweise gleich und betragen üblicherweise jeweils 10 nF bis 1000 nF. Bei lastbedingten Spannungsschwankungen mit Frequenzen, die sich über eine Dekade erstrecken, beispielsweise von 100 kHz bis 10 MHz, können mehrere Pufferkondensatoren 17 mit verschiedenen Pufferkapazitäten parallel geschalten werden. Die Pufferkapazität C errechnet sich in diesem Fall aus der Parallelschaltung der Pufferkondensatoren 17 mit unterschiedlichen Pufferkapazitäten, die beispielsweise zwischen 1 µF und 100 nF liegen.

Bei der ersten bis vierten Anschlussgruppe 8, 9, 10, 11 sind die Versorgungsanschlüsse 5 und in entsprechender Weise die Masseanschlüsse 6 untereinander extern verbunden, wobei ein Masseanschluss 6 jeweils der zweite Masseanschluss 18 ist. Alternativ oder zusätzlich können die Versorgungsanschlüsse 5 und in entsprechender Weise die Masseanschlüsse 6 intern miteinander verbunden sein. Vorteilhafterweise sind die Versorgungsanschlüsse 5 und in entsprechender Weise die Masseanschlüsse 6 untereinander intern verbunden, sofern dies nicht der Fall ist, müssen sie extern verbunden werden.

Die Masseverbindung 13 stellt die einzige Verbindung des integrierten Schaltkreises 4 mit der Schaltungsträgermasse 3 dar, so dass nur der erste Masseanschluss 14 direkt mit der Schaltungsträgermasse 3 verbunden ist. Die weiteren Masseanschlüsse 6, insbesondere die den Pufferkondensatoren 17 zugeordneten zweiten Masseanschlüsse 18, sind extern nicht mit der Schaltungsträgermasse 3 verbunden. Eine Verbindung der weiteren Masseanschlüsse 6, insbesondere der zweiten Masseanschlüsse 18, zu der Schaltungsträgermasse 3 liegt nur schaltkreisintern vor.

Sind die Masseanschlüsse 6, 18 intern nicht verbunden, müssen diese extern verbunden werden. Dabei bleibt die Masseverbindung 13 die ausschließliche Verbindung von der Schaltkreismasse 7 zur Schaltungsträgermasse 3.

Die Schaltungsträgermasse 3 weist im Betrieb aufgrund ihrer endlichen Ausdehnung ein induktives Verhalten auf. Das induktive Verhalten ist im Ersatzschaltbild gemäß Fig. 2 als Schaltungsträgerinduktivität 19 dargestellt. Die Schaltungsträgerinduktivität 19 weist einen Induktivitätswert L auf.

Dadurch, dass die Versorgungseinheit 15 bei der Taktfrequenz f1 und bei höheren Frequenzen, insbesondere bei Vielfachen der Taktfrequenz f1, im Wesentlichen ein Stromquellenverhalten aufweist und die Masseverbindung 13 die einzige Verbindung von der internen Schaltkreismasse 7 zu der Schaltungsträgermasse 3 ist, erfolgt eine Frequenzentkopplung bei der Auf- und der Entladung der extern angeschlossenen Pufferkondensatoren 17 und der internen Schaltkreiskapazität. Das Entladen erfolgt mit der Taktfrequenz f1 und deren Oberwellen, wohingegen das externe Aufladen über den Schaltungsträger 2 mit einer deutlich niedrigeren Frequenz f2 erfolgt. Der Ladekreis wird im Wesentlichen durch die Versorgungseinheit 15, die Pufferkondensatoren 17, die interne Schaltkreiskapazität und die Schaltungsträgerinduktivität 19 gebildet. Die Versorgungseinheit 15 treibt im Ladestromkreis einen Ladestrom I_{L}, der die Pufferkondensatoren 17 und die interne Schaltkreiskapazität lädt und durch die Schaltungsträgerinduktivität 19 fließt. Dadurch, dass die Versorgungseinheit 15 infolge des Stromquellenverhaltens einen hohen Innenwiderstand aufweist, ist im Ladekreis ein RC-Glied ausgebildet, das ein Tiefpassverhalten aufweist. Alternativ oder zusätzlich kann im Ladekreis ein LC-, FerritbeadC-Glied oder eine Kombination der genannten Glieder ausgebildet sein. Infolge dessen erfolgt das Laden niederfrequent mit der Frequenz f2. Der niederfrequente Ladestrom I_{L} fließt zwar durch die Schaltungsträgerinduktivität 19, jedoch ist die Abstrahlung infolge der niedrigen Frequenz f2 sehr gering.

Die Energiezufuhr über die Versorgungseinheit 15 wird niederfrequent, das bedeutet bis etwa 100 kHz so geregelt, dass die Versorgungsspannung des integrierten Schaltkreises 4 in diesem Frequenzbereich die Toleranzvorgaben des Herstellers einhält. Softwarebedingte höherfrequente Spannungsschwankungen werden durch die Pufferkondensatoren 17, die entsprechend ausgelegt sind, so weit minimiert, dass auch in diesem Frequenzbereich die Toleranzvorgaben des Herstellers eingehalten werden.

Der Entladestromkreis wird durch die Schaltkreislast 16, die Pufferkondensatoren 17 und die interne Schaltkreiskapazität gebildet. Beim Entladen fließt durch die Schaltkreislast 16 ein Entladestrom I_{E}. Dadurch, dass die Versorgungseinheit 15 bei der Taktfrequenz f1 und auch bei höheren Frequenzen, insbesondere bei Vielfachen der Taktfrequenz f1, ein Stromquellenverhalten hat und somit einen hochohmigen Innenwiderstand aufweist, fließt durch die Schaltungsträgerinduktivität 19 idealerweise kein hochfrequenter Strom, so dass an der Schaltungsträgerinduktivität 19 keine hochfrequente Spannung abfällt. Der hochfrequente Entladestrom I_{E} ist somit räumlich auf den integrierten Schaltkreis 4 und die Pufferkondensatoren 17 begrenzt. Die Common-Mode-Abstrahlung ist somit beim Entladen sehr gering.

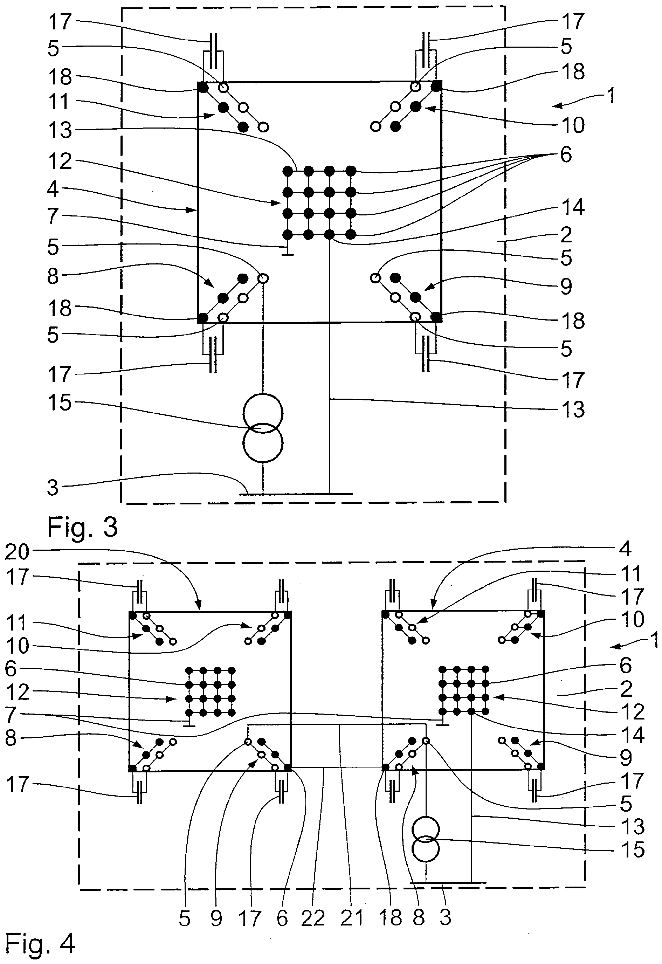

Nachfolgend wird anhand von Fig. 3 ein zweites Ausführungsbeispiel der Erfindung beschrieben. Der wesentliche Unterschied gegenüber dem ersten Ausführungsbeispiel besteht darin, dass die Masseanschlüsse 6 der fünften Anschlussgruppe 12 extern miteinander verbunden sind und mehrere parallele Masseverbindungen 13 zur Schaltungsträgermasse 3 ausbilden. Die Masseanschlüsse 6 sind somit extern mit dem ersten Masseanschluss 14 und der Schaltungsträgermasse 3 verbunden. Dadurch sind die direkt nebeneinander liegenden Masseanschlüsse 6 von der internen Schaltkreismasse 7 zu der Schaltungsträgermasse 3 mittels mehrerer Vias in Pad parallel geschalten. Dies führt zu einer zuverlässigeren und besseren Wärmeableitung aus dem integrierten Schaltkreis 4. Die Verschlechterung des stromgetriebenen Common-Mode-Abstrahlverhaltens ist gering.

Besonders bei Ball-Grid-Array-Gehäusen mit Masseanschlüssen 6 in einem inneren Quadrat, umgeben von einem äußeren quadratischen Ring, wie dies in Fig. 3 dargestellt ist, eignen sich die Masseanschlüsse 6 im inneren Quadrat für das beschriebene Untereinanderverbinden und parallele Anschließen an die Schaltungsträgermasse 3.

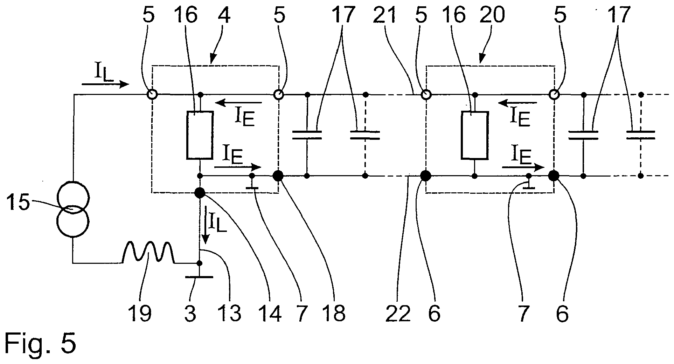

Nachfolgend wird anhand der Fig. 4 und 5 ein drittes Ausführungsbeispiel der Erfindung beschrieben. Der wesentliche Unterschied gegenüber den vorangegangenen Ausführungsbeispielen besteht darin, dass die Schaltungsanordnung 1 zusätzlich zu dem ersten integrierten Schaltkreis 4 einen zweiten integrierten Schaltkreis 20 aufweist. Der zweite integrierte Schaltkreis 20 weist entsprechend zu dem ersten integrierten Schaltkreis 4 angeordnete Versorgungsanschlüsse 5 und Masseanschlüsse 6 auf. Weiterhin ist der zweite integrierte Schaltkreis 20 entsprechend zu dem ersten integrierten Schaltkreis 4 mit Pufferkondensatoren 17, die eine Pufferkapazität C aufweisen, extern beschalten. Der erste integrierte Schaltkreis 4 ist in bekannter Weise mit der Schaltungsträgermasse 3 und der Versorgungseinheit 15 verbunden. Der zweite integrierte Schaltkreis 20 ist ausschließlich über den ersten integrierten Schaltkreis 4 mit der Schaltungsträgermasse 3 verbunden. Ein Versorgungsanschluss 5 der zweiten Anschlussgruppe 9 des zweiten integrierten Schaltkreises 20 ist über eine erste Schaltkreisverbindung 21 direkt mit einem Versorgungsanschluss 5 der ersten Anschlussgruppe 8 des ersten integrierten Schaltkreises 4 verbunden. Weiterhin ist ein Masseanschluss 6 der zweiten Anschlussgruppe 9 des zweiten integrierten Schaltkreises 20 über eine zweite Schaltkreisverbindung 22 direkt mit dem zweiten Masseanschluss 18 der ersten Anschlussgruppe 8 des ersten integrierten Schaltkreises 4 verbunden. Der zweite integrierte Schaltkreis 20 ist somit über die erste und zweite Schaltkreisverbindung 21, 22 an den Pufferkondensator 17, der der ersten Anschlussgruppe 8 des ersten integrierten Schaltkreises 4 zugeordnet ist, angeschlossen. Der zweite integrierte Schaltkreis 20 wird somit über die Schaltkreisverbindungen 21, 22 mit Energie versorgt. Die Anschlussgruppen 8, 9, 10, 11 sowie die Versorgungsanschlüsse 5 und Masseanschlüsse 6 des ersten und zweiten integrierten Schaltkreises 4, 20, welche durch die Schaltkreisverbindungen 21, 22 verbunden werden sollen, können grundsätzlich frei gewählt werden, sofern dadurch die Schaltkreislast 16 und die Pufferkondensatoren 17 des zweiten integrierten Schaltkreises 20 parallel zu denen des ersten integrierten Schaltkreises 4 angeordnet werden. Entscheidend ist, dass von der internen Schaltkreismasse 7 des zweiten integrierten Schaltkreises 20 zu der Schaltungsträgermasse 3 keine direkte externe Verbindung vorhanden ist. Dies gilt entsprechend, wenn weitere integrierte Schaltkreise mittels der Versorgungseinheit 15 mit Energie zu versorgen sind.

Alternativ kann die erste Schaltkreisverbindung 21 von einem Versorgungsanschluss 5 des zweiten integrierten Schaltkreises 20 direkt zu der Versorgungseinheit 15 geführt werden und an diese angeschlossen werden. Die Funktionsweise der Schaltungsanordnung 1 entspricht dem ersten Ausführungsbeispiel.

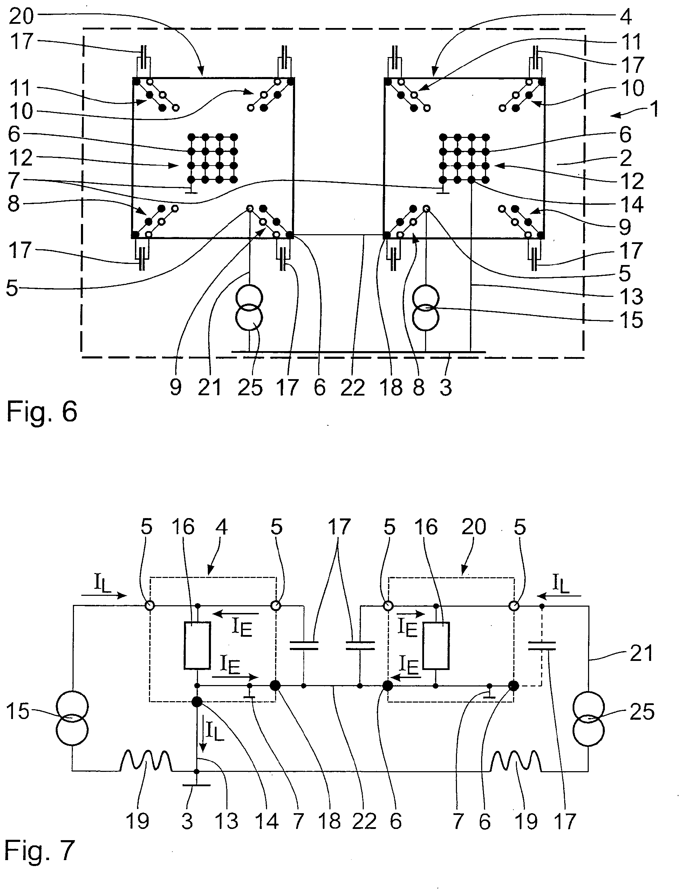

Nachfolgend wird unter Bezugnahme auf die Fig. 6 und 7 ein viertes Ausführungsbeispiel der Erfindung beschrieben. Der wesentliche Unterschied gegenüber dem dritten Ausführungsbeispiel besteht darin, dass die Schaltungsanordnung 1 zusätzlich zu der ersten Versorgungseinheit 15 eine entsprechend ausgebildete zweite Versorgungseinheit 25 zur Versorgung des zweiten integrierten Schaltkreises 20 mit Energie aufweist. Der erste integrierte Schaltkreis 4 ist in bekannter Weise mit der Schaltungsträgermasse 3 und der ersten Versorgungseinheit 15 verbunden. Der zweite integrierte Schaltkreis 20 ist ausschließlich über den ersten integrierten Schaltkreis 4 mit der Schaltungsträgermasse 3 verbunden. Ein Versorgungsanschluss 5 der zweiten Anschlussgruppe 9 des zweiten integrierten Schaltkreises 20 ist über die erste Schaltkreisverbindung 21 direkt mit der zweiten Versorgungseinheit 25 verbunden, die wiederum mit der Schaltungsträgermasse 3 verbunden ist. Weiterhin ist ein Masseanschluss 6 der zweiten Anschlussgruppe 9 des zweiten integrierten Schaltkreises 20 über die zweite Schaltkreisverbindung 22 direkt mit dem zweiten Masseanschluss 18 der ersten Anschlussgruppe 8 des ersten integrierten Schaltkreises 4 verbunden. Entscheidend ist, dass von der internen Schaltkreismasse 7 des zweiten integrierten Schaltkreises 20 zu der Schaltungsträgermasse 3 keine direkte externe Verbindung vorhanden ist. Das Laden der zu dem ersten integrierten Schaltkreis 4 zugehörigen Pufferkondensatoren 17 erfolgt in bekannter Weise mittels der ersten Versorgungseinheit 15. In entsprechender Weise erfolgt das Laden der zu dem zweiten integrierten Schaltkreis 20 zugehörigen Pufferkondensatoren 17 mittels der zweiten Versorgungseinheit 25. Ansonsten entspricht die Funktionsweise der Schaltungsanordnung 1 den vorangegangenen Ausführungsbeispielen.

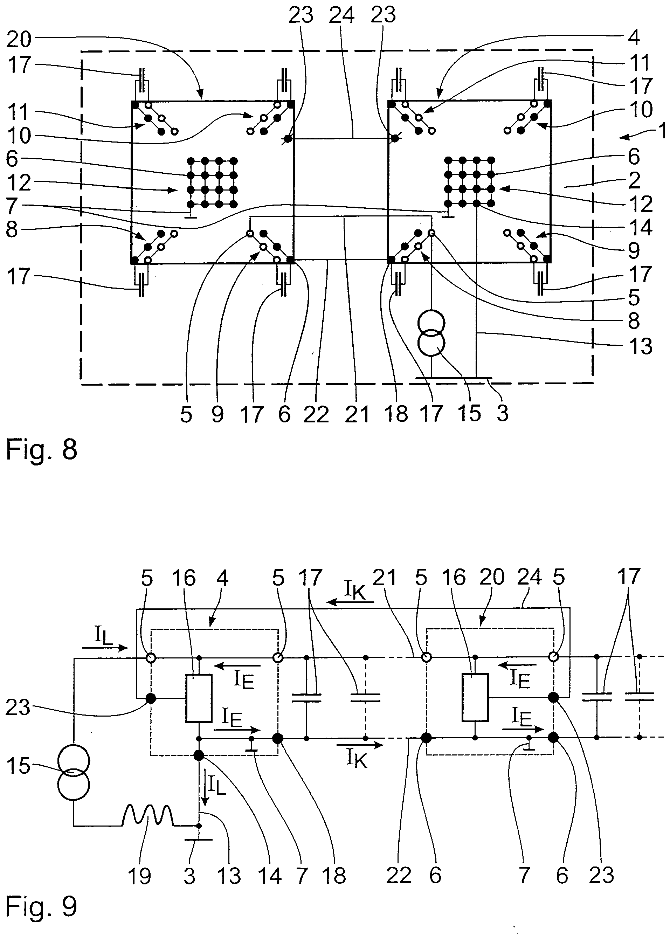

Nachfolgend wird unter Bezugnahme auf die Fig. 8 und 9 ein fünftes Ausführungsbeispiel der Erfindung beschrieben. Der wesentliche Unterschied gegenüber dem dritten Ausführungsbeispiel besteht darin, dass der erste und der zweite integrierte Schaltkreis 4, 20 einen Kommunikationsstromkreis ausbilden. Der Kommunikationsstromkreis ist beispielsweise mittels Daten- oder Adressbusleitungen ausgebildet. Die integrierten Schaltkreise 4, 20 weisen jeweils einen Kommunikationsanschluss 23 auf, die durch eine Kommunikationsverbindung 24 verbunden sind. Der Kommunikationsstromkreis umfasst als Rückleiter die zweite Schaltkreisverbindung 22. In dem Kommunikationsstromkreis fließt ein Kommunikationsstrom I_{K}. Der Kommunikationsstromkreis weist keine eigene Verbindung zu der Schaltungsträgermasse 3 auf. Dies hat zur Folge, dass der Kommunikationsstromkreis nicht die Schaltungsträgerinduktivität 19 umfasst und der Kommunikationsstrom I_{K} keinen Spannungsabfall an der Schaltungsträgerinduktivität 19 verursachen kann. Dies reduziert die stromgetriebene Common-Mode-Abstrahlung des Kommunikationsstromkreises erheblich.

In den Fig. 8 und 9 wurde angenommen, dass sowohl die internen Funktionen der integrierten Schaltkreise 4, 20 als auch der Kommunikationsstromkreis aus dem selben Versorgungsbus des jeweiligen integrierten Schaltkreises 4, 20 gespeist werden. Bei als Mikroprozessoren ausgebildeten integrierten Schaltkreisen 4, 20 ist die Versorgung des Cores, das bedeutet der schnelltaktenden inneren Funktionen, und des Kommunikationsstromkreises üblicherweise getrennt. In diesem Fall muss der Core entsprechend den Fig. 1 bis 7 und der Kommunikationsstromkreis entsprechend den Fig. 8 und 9 angeschlossen werden.

Die erfindungsgemäßen Schaltungsanordnungen 1 erlauben einen integrierten Schaltkreis 4, 20 bei einer hohen Taktfrequenz f1, insbesondere von mehr als 10 MHz, mit elektrischer Energie zu versorgen sowie eine schnelltaktende externe Kommunikation zu realisieren, ohne dass es dabei zu einer nennenswerten Abstrahlung von elektromagnetischer Energie kommt. Durch die Pufferkondensatoren 17 werden Spannungsschwankungen wirkungsvoll vermindert, ohne dass sich die Abstrahlung elektromagnetischer Energie nennenswert erhöht. Die EMV-Anforderungen der Automobilbranche werden somit auch bei Takt- und Busfrequenzen im oberen MHz-Bereich noch eingehalten.

Dadurch, dass die Versorgungseinheit 15 zumindest bei der Taktfrequenz f1 und vorzugsweise auch bei höheren Frequenzen einen Stromquellencharakter aufweist, kommt es zu einer Frequenzentkopplung zwischen dem Lade- und Entladekreis. Die hochfrequenten Entladeströme sind innerhalb der integrierten Schaltkreise 4, 20 und der Pufferkondensatoren 17 eng begrenzt. Die bei einem Entladevorgang über den Schaltungsträger 2 fließenden Ströme sind durch den sehr hohen Innenwiderstand der Versorgungseinheit 15 vernachlässigbar klein, so dass es zu keiner nennenswerten Abstrahlung kommt. Durch Ermangelung einer zweiten Verbindung zwischen der internen Schaltkreismasse 7 und der Schaltungsträgermasse 3, die weit genug von der ersten Verbindung entfernt ist, können sich weiterhin keine hochfrequenten Entladeströme über den Schaltungsträger schließen. Somit erfolgt kein hochfrequenter Spannungsabfall an der unvermeidlichen Schaltungsträgerinduktivität 19, so dass die stromgetriebene Common-Mode-Abstrahlung wirkungsvoll reduziert ist. Die niederfrequenten Ladeströme verursachen infolge der niedrigen Frequenz keine nennenswerte Common-Mode-Abstrahlung.

Bilden die integrierten Schaltkreise 4, 20 mehrere Kommunikationsstromkreise aus, so weist jeder Kommunikationsstromkreis eine eigene Kommunikationsleitung und eine eigene Rückleitung auf, wobei die Kommunikationsleitungen und entsprechend die Rückleitungen nebeneinander oder übereinander in einem konstanten geringen Abstand verlaufen. Mehrere Kommunikationsstromkreise werden entsprechend den Fig. 8 und 9 durch Anschließen der jeweiligen Kommunikationsleitung und Rückleitung an zugehörige Kommunikationsanschlüsse und Masseanschlüsse ausgebildet.

## Patentansprüche

1. Schaltungsanordnung zur Energieversorgung eines integrierten Schaltkreises, umfassend
a. einen Schaltungsträger (2) mit einer elektrischen Schaltungsträgermasse (3),
b. einen eine Taktfrequenz (f1) aufweisenden integrierten Schaltkreis (4) mit
i. einer zu versorgenden Schaltkreislast (16),
ii. zumindest einem Versorgungsanschluss (5),
iii. zumindest einem ersten Masseanschluss (14) und einem zweiten Masseanschluss (18), wobei der erste Masseanschluss (14) über eine Masseverbindung (13) extern mit der Schaltungsträgermasse (3) verbunden ist,
c. eine Versorgungseinheit (15), welche
i. mit dem Versorgungsanschluss (5) verbunden ist, und
ii. derart ausgebildet ist, dass diese zumindest bei der Taktfrequenz (f1) ein Stromquellenverhalten aufweist,
**dadurch gekennzeichnet, dass** die Schaltungsanordnung weiterhin umfasst einen externen Pufferkondensator (17) zur Verminderung von lastbedingten Spannungsschwankungen, wobei der Pufferkondensator (17) parallel zu der Schaltkreislast (16) geschalten ist, und an den Versorgungsanschluss (5) und den zweiten Masseanschluss (18) angeschlossen ist, und
dass ausschließlich der erste Masseanschluss (14) des integrierten Schaltkreises (4) über die Masseverbindung (13) mit der Schaltungsträgermasse (3) extern verbunden ist.

2. Schaltungsanordnung nach Anspruch 1, **dadurch gekennzeichnet, dass** die Versorgungseinheit (15) derart ausgebildet ist, dass diese zumindest bei der Taktfrequenz (f1) und der Taktfrequenz (f1) zugehörigen drei nachfolgenden Oberwellen, insbesondere sieben nachfolgenden Oberwellen und insbesondere zehn nachfolgenden Oberwellen, ein Stromquellenverhalten aufweist.

3. Schaltungsanordnung nach Anspruch 1 oder 2, **dadurch gekennzeichnet, dass** ein weiterer integrierter Schaltkreis (20) vorgesehen ist, welcher ausschließlich über den integrierten Schaltkreis (4) mit der Schaltungsträgermasse (3) verbunden ist.

4. Schaltungsanordnung nach Anspruch 3 , **dadurch gekennzeichnet, dass** der weitere integrierte Schaltkreis (20) einen Versorgungsanschluss (5) und einen Masseanschluss (6) aufweist, wobei zur Energieversorgung der Versorgungsanschluss (5) über eine erste Schaltkreisverbindung (21) und der Masseanschluss (6) über eine zweite Schaltkreisverbindung (22) an den Pufferkondensator (17) des integrierten Schaltkreises (4) angeschlossen ist.

5. Schaltungsanordnung nach Anspruch 3 , **dadurch gekennzeichnet, dass** der weitere integrierte Schaltkreis (20) einen Versorgungsanschluss (5) und einen Masseanschluss (6) aufweist, wobei zur Energieversorgung der Versorgungsanschluss (5) über eine erste Schaltkreisverbindung (21) an die Versorgungseinheit (15) und der Masseanschluss (6) über eine zweite Schaltkreisverbindung (22) und den integrierten Schaltkreis (4) an der Schaltungsträgermasse (3) angeschlossen ist.

6. Schaltungsanordnung nach Anspruch 3 , **dadurch gekennzeichnet, dass** der weitere integrierte Schaltkreis (20) einen Versorgungsanschluss (5) und einen Masseanschluss (6) aufweist, wobei zur Energieversorgung der Versorgungsanschluss (5) über eine erste Schaltkreisverbindung (21) an eine entsprechend zu der Versorgungseinheit (15) ausgebildete weitere Versorgungseinheit (25) und der Masseanschluss (6) über eine zweite Schaltkreisverbindung (22) und den integrierten Schaltkreis (4) an der Schaltungsträgermasse (3) angeschlossen ist.

7. Schaltungsanordnung nach einem der Ansprüche 3 bis 6 , **dadurch gekennzeichnet, dass** ein weiterer externer Pufferkondensator (17) zur Verminderung von lastbedingten Spannungsschwankungen des weiteren integrierten Schaltkreises (20) vorgesehen ist.

8. Schaltungsanordnung nach einem der Ansprüche 3 bis 7 , **dadurch gekennzeichnet, dass** die integrierten Schaltkreise (4, 20) einen Kommunikationsstromkreis ausbilden.

9. Schaltungsanordnung nach Anspruch 8 , **dadurch gekennzeichnet, dass** der Kommunikationsstromkreis als Rückleiter die zweite Schaltkreisverbindung (22) umfasst.

## Claims

1. Circuit arrangement for supplying energy to an integrated circuit comprising
a. a circuit carrier (2) having an electrical circuit carrier earth (3),
b. an integrated circuit (4) having a clock frequency (f1) and having
i. a circuit load (16) to be supplied,
ii. at least one supply terminal (5),
iii. at least one first earth terminal (14) and one second earth terminal (18), wherein the first earth terminal (14) is externally connected to the circuit carrier earth (3) via an earth connection (13),
c. a supply unit (15), which
i. is connected to the supply terminal (5) and
ii. is configured in such a way that said supply unit has a current source behaviour at least at the clock frequency (fl),
**characterized in that** the circuit arrangement furthermore comprises an external buffer capacitor (17) for reducing load-dictated voltage fluctuations, wherein the buffer capacitor (17) is connected in parallel with the circuit load (16) and is connected to the supply terminal (5) and the second earth terminal (18), and
**in that** exclusively the first earth terminal (14) of the integrated circuit (4) is externally connected to the circuit carrier earth (3) via the earth connection (13).

2. Circuit arrangement according to Claim 1, **characterized in that** the supply unit (15) is configured in such a way that it has a current source behaviour at least at the clock frequency (f1) and three subsequent harmonics, in particular seven subsequent harmonics and in particular ten subsequent harmonics, associated with the clock frequency (f1).

3. Circuit arrangement according to Claim 1 or 2, **characterized in that** a further integrated circuit (20) is provided, which is connected to the circuit carrier earth (3) exclusively via the integrated circuit (4).

4. Circuit arrangement according to Claim 3, **characterized in that** the further integrated circuit (20) has a supply terminal (5) and an earth terminal (6), wherein for energy supply purposes the supply terminal (5) is connected via a first circuit connection (21) and the earth terminal (6) is connected via a second circuit connection (22) to the buffer capacitor (17) of the integrated circuit (4).

5. Circuit arrangement according to Claim 3, **characterized in that** the further integrated circuit (20) has a supply terminal (5) and an earth terminal (6), wherein for energy supply purposes the supply terminal (5) is connected to the supply unit (15) via a first circuit connection (21) and the earth terminal (6) is connected to the circuit carrier earth (3) via a second circuit connection (22) and the integrated circuit (4) .

6. Circuit arrangement according to Claim 3, **characterized in that** the further integrated circuit (20) has a supply terminal (5) and an earth terminal (6), wherein for energy supply purposes the supply terminal (5) is connected to a further supply unit (25) configured in a manner corresponding to the supply unit (15) via a first circuit connection (21) and the earth terminal (6) is connected to the circuit carrier earth (3) via a second circuit connection (22) and the integrated circuit (4).

7. Circuit arrangement according to any of Claims 3 to 6, **characterized in that** provision is made of a further external buffer capacitor (17) for reducing load-dictated voltage fluctuations of the further integrated circuit (20).

8. Circuit arrangement according to any of Claims 3 to 7, **characterized in that** the integrated circuits (4, 20) form a communication electric circuit.

9. Circuit arrangement according to Claim 8, **characterized in that** the communication electric circuit comprises the second circuit connection (22) as return conductor.

## Revendications

1. Arrangement de circuit destiné à l'alimentation en énergie d'un circuit intégré, comprenant
a. un porte-circuit (2) ayant une masse de porte-circuit (3),
b. un circuit intégré (4) qui possède une fréquence d'horloge (f1) et comprend
i. une charge de circuit (16) à alimenter,
ii. au moins une borne d'alimentation (5),
iii. au moins une première borne de masse (14) et une deuxième borne de masse (18), la première borne de masse (14) étant reliée extérieurement à la masse de porte-circuit (3) par le biais d'une liaison de masse (13),
c. une unité d'alimentation (15), qui
i. est reliée à la borne d'alimentation (5) et
ii. est configurée de telle sorte que celle-ci présente un comportement de source de courant au moins à la fréquence d'horloge (f1),
**caractérisé en ce que** l'arrangement de circuit comporte en outre un condensateur tampon (17) externe destiné à réduire les fluctuations de tension liées à la charge, le condensateur tampon (17) étant branché en parallèle avec la charge de circuit (16) et étant raccordé à la borne d'alimentation (5) et à la deuxième borne de masse (18), et
**en ce qu'**exclusivement la première borne de masse (14) du circuit intégré (4) est reliée extérieurement à la masse de porte-circuit (3) par le biais de la liaison de masse (13).

2. Arrangement de circuit selon la revendication 1, **caractérisé en ce que** l'unité d'alimentation (15) est configurée de telle sorte que celle-ci présente un comportement de source de courant au moins à la fréquence d'horloge (f1) et aux trois harmoniques suivantes, notamment aux sept harmoniques suivantes et particulièrement aux dix harmoniques suivantes associées à la fréquence d'horloge (f1).

3. Arrangement de circuit selon la revendication 1 ou 2, **caractérisé en ce qu'**un circuit intégré supplémentaire (20) est présent, lequel est relié à la masse de porte-circuit (3) exclusivement par le biais du circuit intégré (4).

4. Arrangement de circuit selon la revendication 3, **caractérisé en ce que** le circuit intégré supplémentaire (20) possède une borne d'alimentation (5) et une borne de masse (6), l'alimentation en énergie étant réalisée par un raccordement de la borne d'alimentation (5) par le biais d'une première liaison de circuit (21) et de la borne de masse (6) par le biais d'une deuxième liaison de circuit (22) au condensateur tampon (17) du circuit intégré (4).

5. Arrangement de circuit selon la revendication 3, **caractérisé en ce que** le circuit intégré supplémentaire (20) possède une borne d'alimentation (5) et une borne de masse (6), l'alimentation en énergie étant réalisée par un raccordement de la borne d'alimentation (5) par le biais d'une première liaison de circuit (21) à l'unité d'alimentation (15) et de la borne de masse (6) par le biais d'une deuxième liaison de circuit (22) et du circuit intégré (4) à la masse de porte-circuit (3).

6. Arrangement de circuit selon la revendication 3, **caractérisé en ce que** le circuit intégré supplémentaire (20) possède une borne d'alimentation (5) et une borne de masse (6), l'alimentation en énergie étant réalisée par un raccordement de la borne d'alimentation (5) par le biais d'une première liaison de circuit (21) à une unité d'alimentation supplémentaire (25) configurée en conformité avec l'unité d'alimentation (15) et de la borne de masse (6) par le biais d'une deuxième liaison de circuit (22) et du circuit intégré (4) à la masse de porte-circuit (3).

7. Arrangement de circuit selon l'une des revendications 3 à 6, **caractérisé en ce qu'**un condensateur tampon externe supplémentaire (17) destiné à réduire les fluctuations de tension liées à la charge du circuit intégré supplémentaire (20) est présent.

8. Arrangement de circuit selon l'une des revendications 3 à 7, **caractérisé en ce que** les circuits intégrés (4, 20) forment un circuit électrique de communication.

9. Arrangement de circuit selon la revendication 8, **caractérisé en ce que** le circuit électrique de communication comprend la deuxième liaison de circuit (22) en tant que conducteur de retour.
